# EUROPÄISCHE PATENTSCHRIFT

(11) **EP 2 255 603 B1**
(45) Veröffentlichungstag und Bekanntmachung des Hinweises auf die Patenterteilung: **05.10.2016**
(21) Anmeldenummer: 09712772.4
(22) Anmeldetag: 11.02.2009
(51) Int. Cl.: H05K 5/00

(54) **VERFAHREN ZUR AUFNAHME EINES ELEKTRISCHEN/ELEKTRONISCHEN BAUTEILS UND ENTSPRECHENDES MONTAGEVERFAHREN SOWIE ABDECKUNG FÜR EINE SOLCHE VORRICHTUNG**
METHOD FOR RECEIVING AN ELECTRIC/ELECTRONIC COMPONENT AND CORRESPONDING MOUNTING METHOD AND COVERING FOR SAID TYPE OF DEVICE
DISPOSITIF POUR RECEVOIR UN COMPOSANT ÉLECTRIQUE/ÉLECTRONIQUE ET PROCÉDÉ DE MONTAGE CORRESPONDANT, ET ÉLÉMENT DE RECOUVREMENT POUR UN TEL DISPOSITIF

(30) Priorität: 20.02.2008 DE 102008009947
(43) Veröffentlichungstag der Anmeldung: 01.12.2010
(73) Patentinhaber: KNORR-BREMSE Systeme für Nutzfahrzeuge GmbH, 80809 München (DE)
(72) Erfinder: EICHNER, Markus, 90408 Nürnberg (DE); UHLAND, Thomas, 74397 Weiler (DE)
(74) Vertreter: Mattusch, Gundula
(86) Internationale Anmeldenummer: PCT/EP2009/000937
(87) Internationale Veröffentlichungsnummer: WO 2009/103447

(56) Entgegenhaltungen:
- EP-A- 0 632 532
- EP-A- 1 622 438
- EP-A- 1 867 874
- DE-A1- 19 541 925

## Beschreibung

Die Erfindung betrifft eine Vorrichtung zur zumindest teilweisen Aufnahme wenigstens eines elektrischen/elektronischen Bauteils in einem Gehäuseinnenraum, insbesondere für Nutzfahrzeuge, mit zumindest einem den Gehäuseinnenraum zumindest teilweise ausbildenden Gehäusebauteil und einer den Gehäuseinnenraum zumindest teilweise abschließenden Abdeckung.

Weiterhin bezieht sich die Erfindung auf ein Verfahren zur Montage einer derartigen Vorrichtung.

Darüber hinaus betrifft die Erfindung eine Abdeckung für eine Vorrichtung zur zumindest teilweisen Aufnahme wenigstens eines elektrischen/elektronischen Bauteils in einem Gehäuseinnenraum, insbesondere für Nutzfahrzeuge, wobei die Abdeckung mit zumindest einem den Gehäuseinnenraum zumindest teilweise ausbildenden Gehäusebauteil koppelbar ist und der Gehäuseinnenraum durch die Abdeckung zumindest teilweise abschließbar ist.

Üblicherweise kommen solche dem Stand der Technik angehörenden Vorrichtungen beispielsweise im Zusammenhang mit Steuergeräten in Nutzfahrzeugen zum Einsatz. Beispielsweise umfassen derartige Steuergeräte unter anderem elektrisch leitfähige Verbindungselemente, insbesondere flexible Leiterplatten, über die die in einem Gehäuseinnenraum aufgenommenen elektrischen und/oder elektronischen Komponenten des Steuergeräts mit außerhalb des Gehäuseinnenraums angeordneten elektrischen und/oder elektronischen Komponenten, beispielsweise mit weiteren Steuergeräten, elektrisch leitfähig gekoppelt werden können. Zur Kopplung der flexiblen Leiterplatte mit den in dem Gehäuseinnenraum aufgenommenen elektrischen/elektronischen Komponenten beziehungsweise mit einem diese Komponenten umfassenden Bauteil, das beispielsweise als starre oder feste Leiterplatte ausgebildet sein kann, ist die Schaffung einer Schnittstelle erforderlich. Üblicherweise wird diese Schnittstelle durch Steckverbinder, d.h. durch Vorsehen eines Steckers an der flexiblen Leiterplatte und eines entsprechenden Gegensteckers an der starren Leiterplatte, oder durch Thermodenlöten, d.h. durch eine Verlötung der flexiblen Leiterplatte mit der starren Leiterplatte, realisiert. Dadurch kann letztendlich eine elektrisch leitfähige Verbindung zwischen einer auf der starren Leiterplatte vorgesehenen Elektronik und weiteren elektrischen/elektronischen Komponenten innerhalb des Nutzfahrzeugs über die flexible Leiterplatte geschaffen werden.

Im Einsatzgebiet von Nutzfahrzeugen sind hohe Anforderungen hinsichtlich einer Schwingfestigkeit und Lebensdauer aller Komponenten, insbesondere der elektrischen/elektronischen Komponenten des Steuergeräts, zu erfüllen. Aus diesem Grund werden beispielsweise die flexiblen Leiterplatten an gewissen Stellen des Steuergeräts fixiert. Eine Möglichkeit der Fixierung der flexiblen Leiterplatte wird beispielsweise dadurch erzielt, dass die flexible Leiterplatte über den Steckverbinder durch zusätzlich daran vorgesehene Klemmelemente fixiert beziehungsweise gehalten wird. Eine weitere Möglichkeit besteht darin, weitere zusätzliche Fixierungsbauteile vorzusehen, beispielsweise an der festen oder starren Leiterplatte, über die ausschließlich die flexible Leiterplatte fixierbar ist. Üblicherweise ist die starre oder feste Leiterplatte an einem Gehäusebauteil des Steuergeräts befestigt und wird zum Schutz, insbesondere zum Berührungsschutz, meist durch eine Abdeckung beziehungsweise Abdeckhaube abgedeckt. Insbesondere während der Montage der flexiblen Leiterplatte, beispielsweise bei der Durchführung der flexiblen Leiterplatte unter oder durch die Abdeckhaube, wird in der Regel keine Dichtung vorgesehen. Für das Abdichten können jedoch nachträglich vorzugsweise extrudierte Dichtungen oder zwischengelegte Dichtungen verwendet werden, die zur Abdichtung der Zwischenräume zwischen der flexiblen Leiterplatte und der Abdeckung/dem Gehäusebauteil dienen. Die aus dem Stand der Technik bekannten Maßnahmen zur Erzielung einer bestimmten Schwingfestigkeit sowie zur Erfüllung der Dichtheitsanforderungen sind jedoch äußerst aufwendig und somit sehr kostspielig.

Eine solche Vorrichtung ist z.B. aus dem Dokument EP-A-0 632 532 bekannt. 5

Der Erfindung liegt daher die Aufgabe zugrunde, die gattungsgemäßen Vorrichtungen, Abdeckungen und Montageverfahren derart weiterzubilden, dass die vorgenannten Nachteile zumindest teilweise in besonders kostengünstiger Weise überwunden werden können.

Diese Aufgabe wird durch die Merkmale der unabhängigen Ansprüche gelöst. Vorteilhafte Ausgestaltungen und Weiterbildungen der Erfindung ergeben sich aus den abhängigen Ansprüchen.

Die erfindungsgemäße Vorrichtung kann in vorteilhafter Weise derart weitergebildet werden, dass das elektrisch leitfähige Verbindungselement zumindest teilweise durch zumindest einen Randabschnitt der Abdeckung fixiert ist, der zumindest abschnittsweise mit zumindest einem Randabschnitt des Gehäusebauteils gekoppelt ist. Vorzugsweise sind die Randabschnitte der Abdeckung mit dem Gehäusebauteil unmittelbar gekoppelt, beispielsweise durch Verschraubung, wodurch beispielsweise der Grad der Fixierung des elektrisch leitfähigen Verbindungselements einstellbar ist. Insbesondere sind die Randabschnitte der Abdeckung, die zur Fixierung des elektrisch leitfähigen Verbindungselements dienen, derart ausgestaltet, dass ein vorbestimmter Zwischenraum für das elektrisch leitfähige Verbindungselement bei mit dem Gehäuseteil verschraubter Abdeckung ausgebildet wird. Beispielsweise kann der zur Fixierung des Verbindungselements vorgesehene Randabschnitt der Abdeckung zumindest teilweise als eine Ausnehmung beziehungsweise Aussparung ausgestaltet sein.

Weiterhin kann die erfindungsgemäße Vorrichtung so verwirklicht werden, dass das elektrisch leitfähige Verbindungselement zwischen dem Gehäusebauteil und der Abdeckung angeordnet ist und zumindest abschnittsweise mit dem Gehäusebauteil und der Abdeckung in Berührung steht. Durch das Zwischenlegen des elektrisch leitfähigen Verbindungselements kann eine Fixierung beispielsweise durch eine Klemmung auf besonders einfache und kostengünstige Weise realisiert werden. Ebenso kann das elektrisch leitfähige Verbindungselement aber auch bereits vor der Klemmung zusätzlich an der Abdeckung befestigt werden, beispielsweise durch Klebung etc.

Darüber hinaus kann die erfindungsgemäße Vorrichtung so ausgebildet werden, dass die Abdeckung derart ausgebildet ist, dass sie zumindest im Bereich der Fixierung des elektrisch leitfähigen Verbindungselements eine Dichtung zumindest teilweise aufnimmt. Insbesondere kann die Abdeckhaube dazu verwendet werden, beispielsweise eine in dem Gehäuseinnenraum aufgenommene Elektronik des elektronischen Bauteils gegen die Umgebung abzudichten und gleichzeitig eine Fixierung beziehungsweise Befestigung des durch die Abdeckung hindurch geführten elektrisch leitfähigen Verbindungselements zu erreichen. In Abhängigkeit von den jeweiligen Dichtheitsanforderungen ist in der Abdeckhaube eine entsprechend ausgelegte Dichtung vorgesehen. Bei der Durchgangstelle des elektrisch leitfähigen Verbindungselements kann sich ohne derartige spezielle Maßnahmen eine Undichtigkeit ergeben, die jedoch erfindungsgemäß durch die Abdeckung verhindert wird. Beispielsweise kann die als separates Bauteil ausgebildete Dichtung bereits vor der Montage der Abdeckung an das Gehäusebauteil an der Abdeckung oder an dem Verbindungselement vorgesehen werden. Alternativ oder zusätzlich kann aber auch eine entsprechende Umspritzung des Verbindungselements vorgenommen werden, so dass die Umspritzung alternativ oder zusätzlich zur separaten Dichtung zur Abdichtung zwischen der Abdeckung und dem Verbindungselement dient. Vorzugsweise ist auch eine Dichtung zwischen dem Verbindungselement und dem Gehäusebauteil vorgesehen, so dass im Wesentlichen zwei Dichtungen im Durchführungsbereich des Verbindungselements durch die Abdeckung aufeinander gepresst werden, nämlich unterhalb und oberhalb des Verbindungselements. Weiterhin ist ebenso denkbar, anstelle der separaten Dichtung oder zusätzlich ein ohnehin zwischen dem Verbindungselement und der Abdeckung/dem Gehäusebauteil aufgetragenes Wärmeleitmedium, insbesondere eine dispensierbare Wärmeleitpaste oder ein Wärmeleitkleber, als Dichtung zu verwenden. So kann beispielsweise unterhalb des Verbindungselements eine extrudierte "Schnur" des Wärmeleitmediums beziehungsweise der Wärmeleitpaste zur Dichtung verwendet werden, während oberhalb des Verbindungselements die entsprechende separate Dichtung zur Abdeckhaube hin zugewandt vorgesehen sein kann.

Ferner kann die erfindungsgemäße Vorrichtung so umgesetzt werden, dass die Abdeckung derart ausgebildet ist, dass sie zumindest an einem die Abdeckung mit dem Gehäusebauteil koppelnden Randabschnitt eine Dichtung aufnimmt, so dass der Randabschnitt die Dichtung zumindest teilweise aufnimmt und das elektrisch leitfähige Verbindungselement fixiert. Insbesondere sind vorzugsweise in dem Randabschnitt, in oder an dem die Dichtung aufgenommen ist, Abschnitte für die aufgenommene Dichtung vorgesehen, um die geforderte Dichtigkeit zwischen der Abdeckung und dem Verbindungselement zu erzielen. Darüber hinaus sind weiterhin Abschnitte vorgesehen, die zur Fixierung des Verbindungselements dienen und vorzugsweise an die Abschnitte zur Aufnahme der Dichtung angrenzen.

In besonders vorteilhafter Weise kann die erfindungsgemäße Vorrichtung derart ausgestaltet werden, dass das elektrisch leitfähige Verbindungselement und/oder das elektrische/elektronische Bauteil zu dessen Fixierung zwischen zumindest einem Randabschnitt des Gehäusebauteils und zumindest einem Randabschnitt der Abdeckung eingeklemmt ist. Durch die Klemmung des elektrisch leitfähigen Verbindungselements zwischen Randabschnitten der Abdeckung und des Gehäusebauteils kann die Fixierung des Verbindungselements auf besonders kostengünstige Weise realisiert werden. Zudem kann vorzugsweise auch das elektrische/elektronische Bauteil zu dessen Fixierung zwischen Randabschnitten der Abdeckung und des Gehäusebauteils eingeklemmt werden. Somit dient die Abdeckung, die insbesondere zur Fixierung des Verbindungselements vorgesehen ist, zusätzlich zur Fixierung des elektrischen/elektronischen Bauteils, das vorzugsweise als feste oder starre Leiterplatte ausgebildet wird. Über eine abgestimmte Auslegung der Nennmaße unter Berücksichtigung entsprechender Toleranzen wird die Leiterplatte über beispielsweise als quasi "federnde Arme" ausgebildete Abschnitte der Abdeckhaube gehalten. Eine Verschraubung der starren oder festen Leiterplatte ist weiterhin möglich, jedoch anhand der Fixierung durch die Abdeckung nicht mehr zwingend erforderlich.

Weiterhin kann die erfindungsgemäße Vorrichtung so realisiert werden, dass das Gehäusebauteil und/oder die Abdeckung zumindest abschnittsweise mit dem elektrischen/elektronischen Bauteil in Berührung steht/stehen, so dass durch das elektrische/elektronische Bauteil erzeugte Wärme durch das Gehäusebauteil und/oder die Abdeckung ableitbar ist. Erzeugt beispielsweise die Elektronik des elektrischen/elektronischen Bauteils eine unzulässig hohe Verlustleistung, kann die starre oder feste Leiterplatte z.B. über ein Wärmeleitmedium an eine Wärmesenke angebunden werden, welche erfindungsgemäß durch das Gehäusebauteil und/oder die Abdeckung verwirklicht wird. Der thermische Kontakt mit der starren oder festen Leiterplatte kann somit anstatt durch eine Verschraubung oder auch zusätzlich über die Verklemmung mit einer entsprechenden Anpresskraft durch das Gehäusebauteil und/oder die Abdeckung erfolgen. Somit dient die Abdeckhaube zusätzlich zur Fixierung der starren oder festen Leiterplatte sowie der flexiblen Leiterplatte auch zur Wärmeableitung. Ferner kann auch durch die Kontaktierung des Gehäusebauteils und/oder der Abdeckung mit dem elektrischen/elektronischen Bauteil eine Masseverbindung hergestellt werden, worauf untenstehend näher eingegangen wird.

Vorzugsweise wird die erfindungsgemäße Vorrichtung so weitergebildet, dass das in dem Gehäuseinneren aufgenommene elektrische/elektronische Bauteil durch eine Leiterplatte, insbesondere eine starr oder fest ausgebildete Leiterplatte, gebildet ist. Im Rahmen dieser Offenbarung werden unter dem Begriff "starre oder feste Leiterplatten" zumindest Leiterplatten in der Form von Leiterkarten, Platinen oder gedruckte Schaltungen (engl. printed wiring board = PWB, printed circuit board = PCB oder etched wiring board = EWB) verstanden, die insbesondere zur mechanischen Befestigung unter gleichzeitiger elektrischer Verbindung von elektrischen/elektronischen Bauteilen dienen.

Weiterhin wird die erfindungsgemäße Vorrichtung bevorzugt so umgesetzt, dass das elektrisch leitfähige Verbindungselement durch eine flexible Leiterplatte, ein umspritztes Stanzgitter oder ein Kabel, insbesondere ein Flachbandkabel, ausgebildet ist.

Bevorzugt wird die erfindungsgemäße Vorrichtung derart ausgestaltet, dass über eine Metallisierung des elektrischen/elektronischen Bauteils ein Massekontakt, insbesondere des elektrischen/elektronischen Bauteils mit dem Gehäusebauteil und/oder der Abdeckung, hergestellt wird. Dadurch wird beispielsweise ein Massepotential hergestellt, das auf Leiterplatten oftmals der umfangreichste Leiterzug sein kann, da daran üblicherweise die meisten an der Leiterplatte vorgesehenen elektronischen Bauteile angeschlossen werden. Oft ist der Leiterzug auch als Fläche über die gesamte Leiterplatte ausgebreitet (Massefläche, Masseebene), um Potentialunterschiede und Störeinflüsse zu vermeiden. Daher wird die Metallisierung des elektrischen/elektronischen Bauteils bedarfsgerecht zumindest abschnittsweise oder an sämtlichen Abschnitten des elektrischen/elektronischen Bauteils vorgenommen.

Das erfindungsgemäße Verfahren zur Montage einer Vorrichtung zur zumindest teilweisen Aufnahme wenigstens eines elektrischen/elektronischen Bauteils wird im Anspruch 11 offenbart.

Gleiches gilt sinngemäß für die folgenden bevorzugten Ausführungsformen des erfindungsgemäßen Verfahrens, wobei auch diesbezüglich zur Vermeidung von Wiederholungen auf die entsprechenden Ausführungen im Zusammenhang mit der erfindungsgemäßen Vorrichtung verwiesen wird.

Das erfindungsgemäße Verfahren kann in vorteilhafter Weise so weitergebildet werden, dass die Abdeckung das elektrisch leitfähige Verbindungselement zumindest teilweise durch zumindest einen Randabschnitt fixiert, der zumindest abschnittsweise mit zumindest einem Randabschnitt des Gehäusebauteils gekoppelt wird.

Weiterhin kann das erfindungsgemäße Verfahren derart realisiert werden, dass das elektrisch leitfähige Verbindungselement zwischen dem Gehäusebauteil und der Abdeckung angeordnet wird und zumindest abschnittsweise mit dem Gehäusebauteil und der Abdeckung in Berührung gebracht wird.

Darüber hinaus kann das erfindungsgemäße Verfahren so verwirklicht werden, dass die Abdeckung zumindest im Bereich der Fixierung des elektrisch leitfähigen Verbindungselements eine Dichtung zumindest teilweise aufnimmt.

Ferner kann das erfindungsgemäße Verfahren derart durchgeführt werden, dass die Abdeckung zumindest an einem die Abdeckung mit dem Gehäusebauteil koppelnden Randabschnitt eine Dichtung aufnimmt, so dass der Randabschnitt die Dichtung zumindest teilweise aufnimmt und das elektrisch leitfähige Verbindungselement fixiert.

Des Weiteren kann das erfindungsgemäße Verfahren so ausgestaltet werden, dass das elektrisch leitfähige Verbindungselement und/oder das elektrische/elektronische Bauteil zu dessen Fixierung zwischen zumindest einem Randabschnitt des Gehäusebauteils und zumindest einem Randabschnitt der Abdeckung eingeklemmt wird.

Weiterhin kann das erfindungsgemäße Verfahren derart ausgeführt werden, dass das Gehäusebauteil und/oder die Abdeckung zumindest abschnittsweise mit dem elektrischen/elektronischen Bauteil in Berührung gebracht wird/werden, so dass durch das elektrische/elektronische Bauteil erzeugte Wärme durch das Gehäusebauteil und/oder die Abdeckung abgeleitet wird.

Vorzugsweise wird das erfindungsgemäße Verfahren derart umgesetzt, dass das in dem Gehäuseinneren aufgenommene elektrische/elektronische Bauteil durch eine Leiterplatte, insbesondere eine starr oder fest ausgebildete Leiterplatte, gebildet ist, die durch die Abdeckung eingeklemmt wird.

Weiterhin kann das erfindungsgemäße Verfahren bevorzugt so weitergebildet werden, dass das elektrisch leitfähige Verbindungselement durch eine flexible Leiterplatte, ein umspritztes Stanzgitter oder ein Kabel, insbesondere ein Flachbandkabel, ausgebildet ist, das durch Montage der Abdeckung fixiert wird.

Ferner kann das erfindungsgemäße Verfahren derart realisiert werden, dass eine Metallisierung des elektrischen/elektronischen Bauteils vorgenommen wird, über die ein Massekontakt, insbesondere des elektrischen/elektronischen Bauteils mit dem Gehäusebauteil und/oder der Abdeckung, hergestellt wird.

Die erfindungsgemäße Abdeckung für eine Vorrichtung zur zumindest teilweisen Aufnahme wenigstens eines elektrischen/elektronischen Bauteils in einem Gehäuseinnenraum wird im Anspruch 21 offenbart.

Die Erfindung wird nun mit Bezug auf die begleitenden Zeichnungen anhand einer bevorzugten Ausführungsform beispielhaft erläutert.

Es zeigen:
- Figur 1: eine schematische Darstellung einer erfindungsgemäßen Vorrichtung in einer Draufsicht;
- Figur 2: eine Seitenansicht der erfindungsgemäßen Vorrichtung von Figur 1 entlang des Schnitts A-A; und
- Figur 3: eine weitere Seitenansicht der erfindungsgemäßen Vorrichtung von Figur 1 entlang des Schnitts B-B.

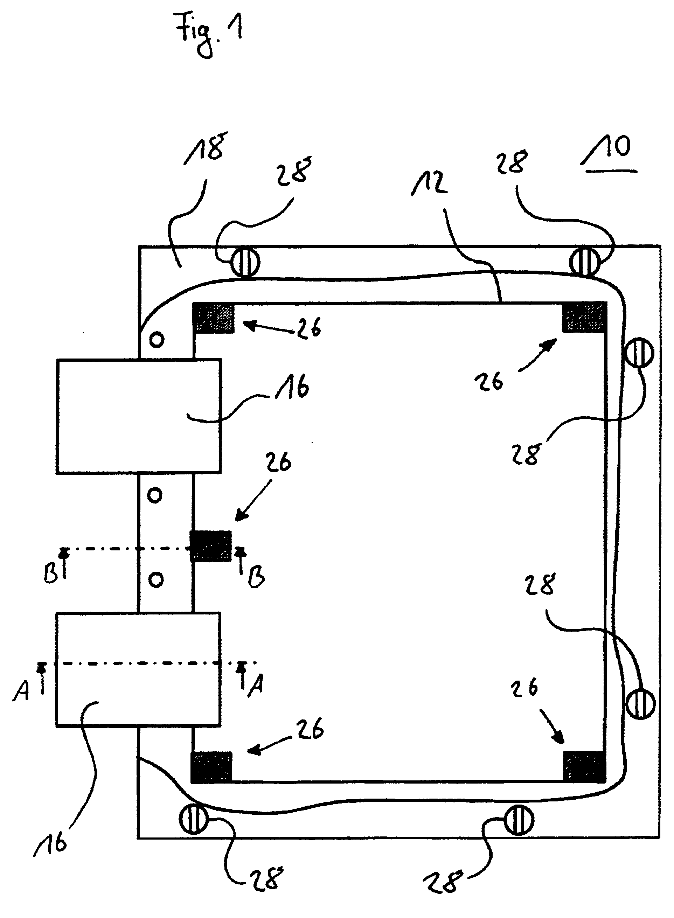

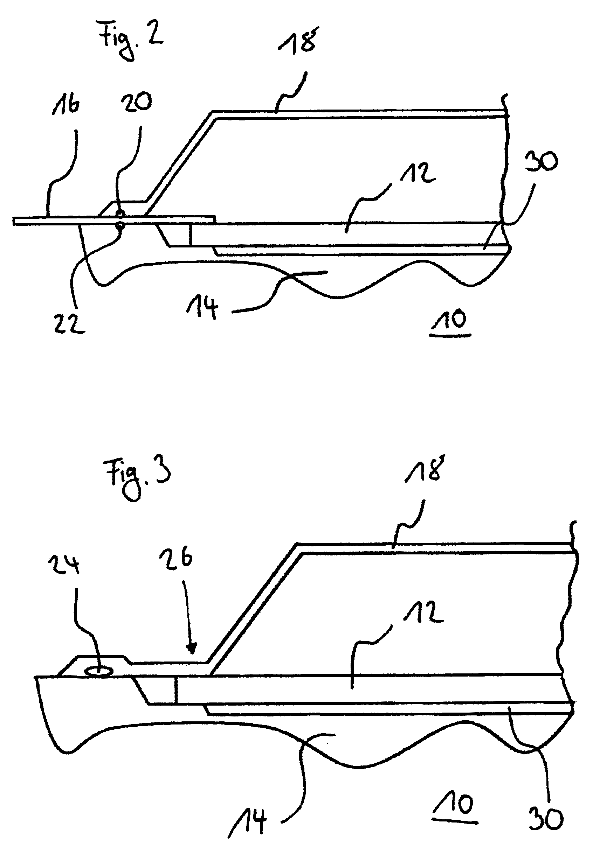

Figur 1 zeigt eine schematische Darstellung einer erfindungsgemäßen Vorrichtung 10 in einer Draufsicht. Darüber hinaus zeigen die Figuren 2 und 3 Seitenansichten der erfindungsgemäßen Vorrichtung 10 von Figur 1 entlang den in Figur 1 angedeuteten unterschiedlichen Schnitten A-A und B-B. Wie aus Figur 1 ersichtlich ist, ist die erfindungsgemäße Vorrichtung 10 zur zumindest teilweisen Aufnahme wenigstens eines elektrischen und/oder elektronischen Bauteils 12, in diesem Ausführungsbeispiel zur vollständigen Aufnahme, in einem Gehäuseinnenraum vorgesehen und findet insbesondere in Nutzfahrzeugen Anwendung. In diesem Fall ist das elektrische und/oder elektronische Bauteil 12 durch eine starr oder fest ausgebildete Leiterplatte 12 ausgebildet, die nicht näher interessierende elektrisch und/oder elektronische Komponenten aufnimmt und zumindest teilweise ein Steuergerät ausbildet. Zur Aufnahme der starr oder fest ausgebildeten Leiterplatte 12 in dem Gehäuseinnenraum umfasst die erfindungsgemäße Vorrichtung 10 ein Gehäuse, das zumindest durch ein den Gehäuseinnenraum zumindest teilweise ausbildendes Gehäusebauteil 14 und eine den Gehäuseinnenraum zumindest teilweise abschließenden Abdeckung beziehungsweise Abdeckhaube 18 ausgebildet wird. Weiterhin umfasst die erfindungsgemäße Vorrichtung 10 zumindest ein elektrisch leitfähiges Verbindungselement 16, im dargestellten Fall zwei elektrisch leitfähige Verbindungselemente 16, die zur elektrischen Kopplung der starr oder fest ausgebildeten Leiterplatte 12 mit zumindest einem außerhalb des Gehäuseinnenraums vorgesehenen weiteren elektrischen und/oder elektronischen Bauteil, beispielsweise einer weiteren Leiterplatte eines weiteren Steuergeräts, vorgesehen sind. Vorzugsweise wird das elektrisch leitfähige Verbindungselement 16 durch eine flexible Leiterplatte, ein umspritztes Stanzgitter oder ein Kabel, insbesondere ein Flachbandkabel, ausgebildet. Zur elektrischen Kopplung der starr oder fest ausgebildeten Leiterplatte 12 mit dem zumindest einen außerhalb des Gehäuseinnenraums vorgesehenen weiteren elektrischen und/oder elektronischen Bauteil ist die Abdeckung 18 derart ausgebildet, dass die elektrisch leitfähigen Verbindungselemente 16 bei an das Gehäusebauteil 14 montierter Abdeckung 18 die Abdeckung 18 durchdringen und/oder vorbeigeführt werden und gleichzeitig durch die Abdeckung 18 fixiert werden. Insbesondere ist in der Figur 2 aus der Seitenansicht der erfindungsgemäßen Vorrichtung 10 von Figur 1 entlang des Schnitts A-A erkennbar, dass die elektrisch leitfähigen Verbindungselemente 16 jeweils durch einen Randabschnitt der Abdeckung 18 fixiert sind, wobei der jeweilige Randabschnitt der Abdeckung 18 zumindest abschnittsweise mit einem entsprechenden Randabschnitt des Gehäusebauteils 14 gekoppelt ist beziehungsweise mit diesem in Berührung steht. Insbesondere sind die zwei in Figur 1 dargestellten elektrisch leitfähigen Verbindungselemente 16 zwischen den entsprechenden Randabschnitten des Gehäusebauteils 14 und der Abdeckung 18 angeordnet, wie insbesondere der Figur 2 zu entnehmen ist. Anhand der Fixierung der Abdeckung 18 an dem Gehäusebauteil 14, die in diesem Ausführungsbeispiel wie in Figur 1 gezeigt durch eine entsprechende Verschraubung 28 vorgenommen wird, sind die elektrisch leitfähigen Verbindungselemente 16 zu dessen Fixierung zwischen den entsprechenden Randabschnitten des Gehäusebauteils 14 und der Abdeckung 18 somit eingeklemmt. Um das entsprechende Verbindungselement 16 jedoch nicht zu beschädigen, ist die Abdeckung 18 derart ausgebildet, dass sie im an das Gehäusebauteil 14 montierten Zustand eine vorbestimmten Zwischenraum zwischen den Randabschnitten der Abdeckung 18 und dem Gehäusebauteil 14 ausbildet; beispielsweise anhand einer in der Abdeckung 18 ausgebildeten Ausnehmung oder Aussparung. Darüber hinaus ist aus Figur 2 ersichtlich, dass oberhalb und unterhalb des jeweiligen elektrisch leitfähigen Verbindungselements 16 eine Dichtung 20 in der Abdeckung 18 und eine Dichtung 22 in dem Gehäusebauteil vorgesehen sind; insbesondere sind die Dichtungen 20, 22 zumindest im Bereich der Fixierung des jeweiligen elektrisch leitfähigen Verbindungselements 16 vorgesehen und werden zumindest teilweise von der Abdeckung 18 und dem Gehäusebauteil 14 aufgenommen. Somit dienen die entsprechenden das jeweilige elektrisch leitfähige Verbindungselement 16 fixierenden Randabschnitte der Abdeckung 18 nicht lediglich zur Fixierung, sondern sind gleichzeitig zur Abdichtung des Gehäuseinnenraums gegenüber einer Umgebung vorgesehen.

Wie insbesondere aus Figur 3 ersichtlich ist, ist der weiteren Seitenansicht der erfindungsgemäßen Vorrichtung 10 von Figur 1 entlang des Schnitts B-B zu entnehmen, dass die Abdeckung 18 weiterhin die fest oder starr ausgebildete Leiterplatte 12 fixiert. Insbesondere sind zur Fixierung der fest oder starr ausgebildeten Leiterplatte 12 weitere Randabschnitte der Abdeckung 18 vorgesehen, die die fest oder starr ausgebildete Leiterplatte 12 zwischen einem Randabschnitt des Gehäusebauteils 14 und dem Randabschnitt der Abdeckung 18 einklemmen und dadurch eine Klemmung 26 für die Leiterplatte 12 ausbilden. Insbesondere können die die Leiterplatte 12 klemmenden Randabschnitte der Abdeckung 18 als quasi "federnde Arme" gesehen im Schnitt B-B ausgelegt sein, die dergestalt ausgebildet sind, dass ein Abschnitt des entsprechenden federnden Armes unmittelbar mit dem Gehäusebauteil gekoppelt ist, während ein benachbarter angrenzender Abschnitt des entsprechenden federnden Armes die Klemmung 26 ausbildet. In diesem Zusammenhang ist vorzugsweise ein Wärmeleitmedium 30, insbesondere eine Wärmeleitpaste, an der Klemmung 26, d.h. zwischen Leiterplatte 12 und dem Gehäusebauteil 14 und/oder zwischen der Abdeckung 18 und der Leiterplatte 12 (nicht dargestellt) vorgesehen, so dass durch die Berührung beziehungsweise Klemmung 26 der Abdeckung 18 mit der Leiterplatte 12 und/oder des Gehäusebauteils 14 mit der Leiterplatte 12 Wärme über das Wärmeleitmedium und das Gehäusebauteil und/oder die Abdeckung 18 ableitbar beziehungsweise abführbar ist. Darüber hinaus sind zumindest auch in den Bereichen der Klemmung 26 im äußeren Bereich der Abdeckung 18 Dichtungen 24 in der Abdeckung 18 zumindest teilweise aufgenommen.

Das erfindungsgemäße Verfahren zur Montage der erfindungsgemäßen Vorrichtung 10 zur in diesem Ausführungsbeispiel vollständigen Aufnahme der starr oder fest ausgebildeten Leiterplatte 12 in dem Gehäuseinnenraum gestaltet sich wie folgt. Die starr oder fest ausgebildete Leiterplatte 12 wird mit den entsprechenden elektrisch leitfähigen Verbindungselementen 16 gekoppelt und in dem Gehäuseteil 14 angeordnet oder umgekehrt. Anschließend wird die Abdeckung 18 derart an dem Gehäusebauteil 14 über die Verschraubung 28 oder alternativ über eine vergleichbare aus dem Stand der Technik bekannte Befestigung montiert, dass sie zum einen das elektrisch leitfähige Verbindungselement 16 fixiert beziehungsweise das Verbindungselement 16 zwischen dem Gehäusebauteil 14 und der Abdeckung 18 einklemmt. Zum anderen wird durch die Montage der Abdeckung 18 auch die fest oder starr ausgebildete Leiterplatte 12 über die Klemmung 26 fixiert, so dass sie zu dessen Fixierung zwischen zumindest dem weiteren Randabschnitt des Gehäusebauteils 14 und dem weiteren Randabschnitt der Abdeckung 18 eingeklemmt wird.

### Bezugszeichenliste:

- 10: Vorrichtung
- 12: (starre bzw. feste) Leiterplatte
- 14: Gehäusebauteil
- 16: elektrisches Verbindungselement
- 18: Abdeckung beziehungsweise Abdeckhaube
- 20: Dichtung
- 22: Dichtung
- 24: Dichtung
- 26: Klemmung
- 28: Verschraubung
- 30: Wärmeleitmedium

## Patentansprüche

1. Vorrichtung (10) zur zumindest teilweisen Aufnahme wenigstens eines elektrischen/elektronischen Bauteils (12) in einem Gehäuseinnenraum, insbesondere für Nutzfahrzeuge, mit zumindest einem den Gehäuseinnenraum zumindest teilweise ausbildenden Gehäusebauteil (14) und einer den Gehäuseinnenraum zumindest teilweise abschließenden Abdeckung (18), wobei die Abdeckung (18) derart ausgebildet ist, dass zumindest ein elektrisch leitfähiges Verbindungselement (16) zur elektrischen Kopplung des elektrischen/elektronischen Bauteils (12) mit zumindest einem außerhalb des Gehäuseinnenraums vorgesehenen weiteren elektrischen/elektronischen Bauteil durch die Abdeckung (18) fixiert ist, und wobei das elektrische/elektronische Bauteil (12) zur Fixierung zwischen zumindest einem Randabschnitt des Gehäusebauteils (14) und zumindest einem Randabschnitt der Abdeckung (18) eingeklemmt ist, **dadurch gekennzeichnet, dass** der das elektrische/elektronische Bauteil (12) einklemmende zumindest eine Randabschnitt der Abdeckung (18) als federnder Arm ausgebildet ist, wobei ein erster Abschnitt des federnden Arms unmittelbar mit dem zumindest einen Randabschnitt des Gehäusebauteils (14) gekoppelt ist, während ein benachbarter angrenzender zweiter Abschnitt des federnden Arms zusammen mit dem Gehäusebauteil (14) eine Klemmung (26) ausbildet.

2. Vorrichtung nach Anspruch 1, **dadurch gekennzeichnet, dass** das elektrisch leitfähige Verbindungselement (16) zumindest teilweise durch zumindest einen weiteren Randabschnitt der Abdeckung (18) fixiert ist, der zumindest abschnittsweise mit zumindest einem weiteren Randabschnitt des Gehäusebauteils (14) gekoppelt ist.

3. Vorrichtung nach einem der Ansprüche 1 oder 2, **dadurch gekennzeichnet, dass** das elektrisch leitfähige Verbindungselement (16) zwischen dem Gehäusebauteil (14) und der Abdeckung (18) angeordnet ist und zumindest abschnittsweise mit dem Gehäusebauteil (14) und der Abdeckung (18) in Berührung steht.

4. Vorrichtung nach einem der Ansprüche 1 bis 3, **dadurch gekennzeichnet, dass** die Abdeckung (18) derart ausgebildet ist, dass sie zumindest im Bereich der Fixierung des elektrisch leitfähigen Verbindungselements (16) eine Dichtung (20) zumindest teilweise aufnimmt.

5. Vorrichtung nach einem der Ansprüche 1 bis 4, **dadurch gekennzeichnet, dass** die Abdeckung (18) derart ausgebildet ist, dass sie zumindest an einem die Abdeckung (18) mit dem Gehäusebauteil (14) koppelnden weiteren Randabschnitt eine Dichtung (20) aufnimmt, so dass der weitere Randabschnitt die Dichtung (20) zumindest teilweise aufnimmt und das elektrisch leitfähige Verbindungselement (16) fixiert.

6. Vorrichtung nach einem der Ansprüche 1 bis 5, **dadurch gekennzeichnet, dass** das elektrisch leitfähige Verbindungselement (16) zur Fixierung zwischen zumindest einem weiteren Randabschnitt des Gehäusebauteils (14) und zumindest einem weiteren Randabschnitt der Abdeckung (18) eingeklemmt ist, und

7. Vorrichtung nach einem der Ansprüche 1 bis 6, **dadurch gekennzeichnet, dass** das Gehäusebauteil (14) und/oder die Abdeckung (18) zumindest abschnittsweise mit dem elektrischen/elektronischen Bauteil (12) in Berührung steht/stehen, so dass durch das elektrische/elektronische Bauteil (12) erzeugte Wärme durch das Gehäusebauteil (14) und/oder die Abdeckung (18) ableitbar ist.

8. Vorrichtung nach einem der Ansprüche 1 bis 7, **dadurch gekennzeichnet, dass** das in dem Gehäuseinneren aufgenommene elektrische/elektronische Bauteil (12) durch eine Leiterplatte, insbesondere eine starr oder fest ausgebildete Leiterplatte, gebildet ist.

9. Vorrichtung nach einem der Ansprüche 1 bis 8, **dadurch gekennzeichnet, dass** das elektrisch leitfähige Verbindungselement (16) durch eine flexible Leiterplatte, ein umspritztes Stanzgitter oder ein Kabel, insbesondere ein Flachbandkabel, ausgebildet ist.

10. Vorrichtung nach einem der Ansprüche 1 bis 9, **dadurch gekennzeichnet, dass** über eine Metallisierung des elektrischen/elektronischen Bauteils (12) ein Massekontakt, insbesondere des elektrischen/elektronischen Bauteils (12) mit dem Gehäusebauteil (14) und/oder der Abdeckung (18), hergestellt wird.

11. Verfahren zur Montage einer Vorrichtung (10) zur zumindest teilweisen Aufnahme wenigstens eines elektrischen/elektronischen Bauteils (12) in einem Gehäuseinnenraum, insbesondere für Nutzfahrzeuge, wobei die Vorrichtung zumindest ein den Gehäuseinnenraum zumindest teilweise ausbildendes Gehäusebauteil (14) und eine den Gehäuseinnenraum zumindest teilweise abschließende Abdeckung (18) aufweist, wobei zumindest ein elektrisch leitfähiges Verbindungselement (16) zur elektrischen Kopplung des elektrischen/elektronischen Bauteils (12) mit zumindest einem außerhalb des Gehäuseinnenraums vorgesehenen weiteren elektrischen/elektronischen Bauteil durch die Abdeckung (18) fixiert wird, und wobei das elektrische/elektronische Bauteil (12) zur Fixierung zwischen zumindest einem Randabschnitt des Gehäusebauteils (14) und zumindest einem Randabschnitt der Abdeckung (18) eingeklemmt wird, **dadurch gekennzeichnet, dass** der das elektrische/elektronische Bauteil (12) einklemmende zumindest eine Randabschnitt der Abdeckung (18) als federnder Arm ausgebildet wird, wobei ein erster Abschnitt des federnden Arms unmittelbar mit dem zumindest einen Randabschnitt des Gehäusebauteils (14) gekoppelt wird, während ein benachbarter angrenzender zweiter Abschnitt des federnden Arms mit dem Gehäusebauteil (14) eine Klemmung (26) ausgebildet.

12. Verfahren nach Anspruch 11, **dadurch gekennzeichnet, dass** die Abdeckung (18) das elektrisch leitfähige Verbindungselement (16) zumindest teilweise durch zumindest einen weiteren Randabschnitt fixiert, der zumindest abschnittsweise mit zumindest einem weiteren Randabschnitt des Gehäusebauteils (14) gekoppelt wird.

13. Verfahren nach einem der Ansprüche 11 oder 12, **dadurch gekennzeichnet, dass** das elektrisch leitfähige Verbindungselement (16) zwischen dem Gehäusebauteil (14) und der Abdeckung (18) angeordnet wird und zumindest abschnittsweise mit dem Gehäusebauteil (14) und der Abdeckung (18) in Berührung gebracht wird.

14. Verfahren nach einem der Ansprüche 11 bis 13, **dadurch gekennzeichnet, dass** die Abdeckung (18) zumindest im Bereich der Fixierung des elektrisch leitfähigen Verbindungselements (16) eine Dichtung (20) zumindest teilweise aufnimmt.

15. Verfahren nach einem der Ansprüche 11 bis 14, **dadurch gekennzeichnet, dass** die Abdeckung (18) zumindest an einem die Abdeckung (18) mit dem Gehäusebauteil (14) koppelnden weiteren Randabschnitt eine Dichtung (20) aufnimmt, so dass der weitere Randabschnitt die Dichtung (20) zumindest teilweise aufnimmt und das elektrisch leitfähige Verbindungselement (16) fixiert.

16. Verfahren nach einem der Ansprüche 11 bis 15, **dadurch gekennzeichnet, dass** das elektrisch leitfähige Verbindungselement (16) zur Fixierung zwischen zumindest einem weiteren Randabschnitt des Gehäusebauteils (14) und zumindest einem weiteren Randabschnitt der Abdeckung (18) eingeklemmt wird.

17. Verfahren nach einem der Ansprüche 11 bis 16, **dadurch gekennzeichnet, dass** das in dem Gehäuseinneren aufgenommene elektrische/elektronische Bauteil (12) durch eine Leiterplatte, insbesondere eine starr oder fest ausgebildete Leiterplatte, gebildet ist, die durch die Abdeckung (18) eingeklemmt wird.

18. Verfahren nach einem der Ansprüche 11 bis 17, **dadurch gekennzeichnet, dass** das Gehäusebauteil (14) und/oder die Abdeckung (18) zumindest abschnittsweise mit dem elektrischen/elektronischen Bauteil (12) in Berührung gebracht wird/werden, so dass durch das elektrische/elektronische Bauteil (12) erzeugte Wärme durch das Gehäusebauteil (14) und/oder die Abdeckung (18) abgeleitet wird.

19. Verfahren nach einem der Ansprüche 11 bis 18, **dadurch gekennzeichnet, dass** das elektrisch leitfähige Verbindungselement (16) durch eine flexible Leiterplatte, ein umspritztes Stanzgitter oder ein Kabel, insbesondere ein Flachbandkabel, ausgebildet ist, das durch Montage der Abdeckung (18) fixiert wird.

20. Verfahren nach einem der Ansprüche 11 bis 19, **dadurch gekennzeichnet, dass** eine Metallisierung des elektrischen/elektronischen Bauteils (12) vorgenommen wird, über die ein Massekontakt, insbesondere des elektrischen/elektronischen Bauteils (12) mit dem Gehäusebauteil (14) und/oder der Abdeckung (18), hergestellt wird.

21. Abdeckung (18) für eine Vorrichtung (10) zur zumindest teilweisen Aufnahme wenigstens eines elektrischen/elektronischen Bauteils (12) in einem Gehäuseinnenraum, insbesondere für Nutzfahrzeuge, wobei die Abdeckung (18) mit zumindest einem den Gehäuseinnenraum zumindest teilweise ausbildenden Gehäusebauteil (14) koppelbar ist und der Gehäuseinnenraum durch die Abdeckung (18) zumindest teilweise abschließbar ist, wobei die Abdeckung (18) derart ausgebildet ist, dass zumindest ein elektrisch leitfähiges Verbindungselement (16) zur elektrischen Kopplung des elektrischen/elektronischen Bauteils (12) mit zumindest einem außerhalb des Gehäuseinnenraums vorgesehenen weiteren elektrischen/elektronischen Bauteil bei Kopplung der Abdeckung (18) mit dem Gehäusebauteil (14) durch die Abdeckung (18) fixierbar ist, und wobei die Abdeckung (14) derart ausgebildet ist, dass das elektrische/elektronische Bauteil (12) zwischen zumindest einem Randabschnitt des Gehäusebauteils (14) und zumindest einem Randabschnitt der Abdeckung (18) einklemmbar ist, **dadurch gekennzeichnet, dass** der zumindest eine Randabschnitt der Abdeckung (18) als federnder Arm ausgebildet ist, wobei ein erster Abschnitt des federnden Arms unmittelbar mit dem zumindest einen Randabschnitt des Gehäusebauteils (14) koppelbar ist, während ein benachbarter angrenzender zweiter Abschnitt des federnden Arms zusammen mit dem Gehäusebauteil (14) im gekoppelten Zustand der Abdeckung (18) eine Klemmung (26) ausbildet.

## Claims

1. Apparatus (10) for at least partially holding at least one electrical/electronic component (12) in a housing internal area, in particular for commercial vehicles, having at least one housing component (14) which at least partially forms the housing internal area, and having a cover (18) which at least partially closes the housing internal area, wherein the cover (18) is designed such that at least one electrically conductive connecting element (16) for electrical coupling of the electrical/electronic component (12) to at least one further electrical/electronic component which is provided outside the housing internal area is fixed by the cover (18), and wherein the electrical/electronic component (12) is clamped in in order to be fixed between at least one edge section of the housing component (14) and at least one edge section of the cover (18), **characterized in that** the at least one edge section of the cover (18), which edge section clamps in the electrical/electronic component (12), is in the form of a sprung arm, wherein a first section of the sprung arm is directly coupled to the at least one edge section of the housing component (14), while a neighbouring adjacent second section of the sprung arm forms a clamp (26) together with the housing component (14).

2. Apparatus according to Claim 1, **characterized in that** the electrically conductive connecting element (16) is at least partially fixed by at least one further edge section of the cover (18), which is coupled at least in places to at least one further edge section of the housing component (14).

3. Apparatus according to one of Claims 1 and 2, **characterized in that** the electrically conductive connecting element (16) is arranged between the housing component (14) and the cover (18) and, at least in places, touches the housing component (14) and the cover (18).

4. Apparatus according to one of Claims 1 and 3, **characterized in that** the cover (18) is designed such that it at least partially holds a seal (20), at least in the area of the fixing of the electrically conductive connecting element (16).

5. Apparatus according to one of Claims 1 to 4, **characterized in that** the cover (18) is designed such that it holds a seal (20) at least on a further edge section which couples the cover (18) to the housing component (14), such that the further edge section at least partially holds the seal (20) and fixes the electrically conductive connecting element (16).

6. Apparatus according to one of Claims 1 to 5, **characterized in that** the electrically conductive connecting element (16) is clamped in in order to be fixed between at least one further edge section of the housing component (14) and at least one further edge section of the cover (18), and

7. Apparatus according to one of Claims 1 to 6, **characterized in that** the housing component (14) and/or the cover (18) touch or touches the electrical/electronic component (12) at least in places, such that heat produced by the electrical/electronic component (12) can be dissipated through the housing component (14) and/or the cover (18).

8. Apparatus according to one of Claims 1 to 7, **characterized in that** the electrical/electronic component (12) which is held in the housing interior is formed by a printed circuit board, in particular a rigid or fixed printed circuit board.

9. Apparatus according to one of Claims 1 to 8, **characterized in that** the electrically conductive connecting element (16) is formed by a flexible printed circuit, an insertion-molded stamped grid or a cable, in particular a flat ribbon cable.

10. Apparatus according to one of Claims 1 to 9, **characterized in that** a ground contact, in particular of the electrical/electronic component (12) to the housing component (14) and/or to the cover (18), is produced via metalization on the electrical/electronic component (12).

11. Method for assembling an apparatus (10) for at least partially holding at least one electrical/electronic component (12) in a housing internal area, in particular for commercial vehicles, wherein the apparatus has at least one housing component (14), which at least partially forms the housing internal area, and a cover (18), which at least partially closes the housing internal area, wherein at least one electrically conductive connecting element (16) for electrical coupling of the electrical/electronic component (12) to at least one further electrical/electronic component which is provided outside the housing internal area is fixed by the cover (18), and wherein the electrical/electronic component (12) is clamped in in order to be fixed between at least one edge section of the housing component (14) and at least one edge section of the cover (18), **characterized in that** the at least one edge section of the cover (18), which edge section clamps in the electrical/electronic component (12), is in the form of a sprung arm, wherein a first section of the sprung arm is directly coupled to the at least one edge section of the housing component (14), while a neighbouring adjacent second section of the sprung arm forms a clamp (26) together with the housing component (14).

12. Method according to Claim 11, **characterized in that** the cover (18) at least partially fixes the electrically conductive connecting element (16) by means of at least one further edge section which is coupled, at least in places, to at least one further edge section of the housing component (14).

13. Method according to one of Claims 11 or 12, **characterized in that** the electrically conductive connecting element (16) is arranged between the housing component (14) and the cover (18) and, at least in places, touches the housing component (14) and the cover (18).

14. Method according to one of Claims 11 to 13, **characterized in that** the cover (18) at least partially holds a seal (20), at least in the area of the fixing of the electrically conductive connecting element (16).

15. Method according to one of Claims 11 to 14, **characterized in that** the cover (18) holds a seal (20) at least on a further edge section which couples the cover (18) to the housing component (14), such that the further edge section at least partially holds the seal (20) and fixes the electrically conductive connecting element (16).

16. Method according to one of Claims 11 to 15, **characterized in that** the electrically conductive connecting element (16) is clamped in in order to be fixed between at least one further edge section of the housing component (14) and at least one further edge section of the cover (18).

17. Method according to one of Claims 11 to 16, **characterized in that** the electrical/electronic component (12) which is held in the housing interior is formed by a printed circuit board, in particular a rigid or fixed printed circuit board, which is clamped in by the cover (18).

18. Method according to one of Claims 11 to 17, **characterized in that** the housing component (14) and/or the cover (18) touch or touches the electrical/electronic component (12) at least in places, such that heat produced by the electrical/electronic component (12) is dissipated through the housing component (14) and/or the cover (18).

19. Method according to one of Claims 11 to 18, **characterized in that** the electrically conductive connecting element (16) is formed by a flexible printed circuit, an insertion-molded stamped grid or a cable, in particular a flat ribbon cable, which is fixed by fitting the cover (18).

20. Method according to one of Claims 11 to 19, **characterized in that** the electrical/electronic component (12) is metalized, via which metalization a ground contact is produced, in particular of the electrical/electronic component (12) to the housing component (14) and/or the cover (18).

21. Cover (18) for an apparatus (10) for at least partially holding at least one electrical/electronic component (12) in a housing internal area, in particular for commercial vehicles, wherein the cover (18) can be coupled to at least one housing component (14), which at least partially forms the housing internal area, and the housing internal area can be at least partially closed by the cover (18), wherein the cover (18) is designed such that at least one electrically conductive connecting element (16) for electrical coupling of the electrical/electronic component (12) to at least one further electrical/electronic component which is provided outside the housing internal area can be fixed' by the cover (18) when the cover (18) is coupled to the housing component (14), and wherein the cover (14) is formed in such a way that the electrical/electronic component (12) can be clamped in between at least one edge section of the housing component (14) and at least one edge section of the cover (18), **characterized in that** the at least one edge section of the cover (18) is in the form of a sprung arm, wherein a first section of the sprung arm can be directly coupled to the at least one edge section of the housing component (14), while a neighbouring adjacent second section of the sprung arm forms a clamp (26) together with the housing component (14) in the coupled state of the cover (18).

## Revendications

1. Dispositif (10) à recevoir, au moins en partie, au moins un composant électrique/électronique (12) dans un espace intérieur de boîte, en particulier pour des véhicules utilitaires, comprenant au moins un composant de boîte (14) formant ledit espace intérieur de boîte, au moins en partie, et une couverture (18) fermant, au moins en partie, ledit espace intérieur de boîte, dans lequel ladite couverture (18) est configurée d'une telle façon, qu'au moins un élément de liaison électriquement conducteur (16) pour un couplage électrique dudit composant électrique/électronique (12) à au moins un autre composant électrique/électronique, disposé en dehors dudit espace intérieur de boîte, soit fixé moyennant ladite couverture (18), et dans lequel ledit composant électrique/électronique (12) est serré, pour sa fixation, entre au moins une partie de bord dudit composant de boîte (14) et au moins une partie de bord de ladite couverture (18), **caractérisé en ce que** ladite au moins une partie de bord de ladite couverture (18), qui serre ledit composant électrique/électronique, est configurée sous forme d'un bras élastique, à une première partie dudit bras élastique étant accouplée directement à ladite au moins une partie de bord dudit composant de boîte (14), pendant qu'une deuxième partie adjacente contigüe dudit bras élastique constitue un serrage (26) ensemble avec ledit composant de boîte (14).

2. Dispositif selon la revendication 1, **caractérisé en ce que** ledit élément de liaison électriquement conducteur (16) est fixé, au moins en partie, par au moins une autre partie de bord de ladite couverture (18), qui est accouplée, au moins par tronçons respectifs, à au moins une autre partie de bord dudit composant de boîte (14).

3. Dispositif selon une quelconque des revendications 1 ou 2, **caractérisé en ce que** ledit élément de liaison électriquement conducteur (16) est disposé entre ledit composé de boîte (14) et ladite couverture (18) et se trouve en contact, au moins par tronçons respectifs, avec ledit composant de boîte (14) et ladite couverture (18).

4. Dispositif selon une quelconque des revendications 1 à 3, **caractérisé en ce que** ladite couverture (18) est configurée d'une telle façon, qu'elle reçoive, au moins en partie, un joint d'étanchéité (20) au moins dans la zone de la fixation dudit élément de liaison électriquement conducteur (16).

5. Dispositif selon une quelconque des revendications 1 à 4, **caractérisé en ce que** ladite couverture (18) est configurée d'une telle façon, qu'elle reçoive un joint d'étanchéité (20) au moins à une autre partie de bord, qui accouple ladite couverture (18) audit composant de boîte (14), de manière, que ladite autre partie de bord reçoive, au moins en partie, ledit joint d'étanchéité (20), en fixant ledit élément de liaison électriquement conducteur (16).

6. Dispositif selon une quelconque des revendications 1 à 5, **caractérisé en ce que** ledit élément de liaison électriquement conducteur (16) est serré pour sa fixation entre au moins une autre partie de bord dudit composant de boîte (14) et au moins une autre partie de bord de ladite couverture (18).

7. Dispositif selon une quelconque des revendications 1 à 6, **caractérisé en ce que** ledit composant de boîte (14) et/ou ladite couverture (18) se trouvent en contact, au moins par tronçons respectifs, avec ledit composant électrique/électronique (12), de façon, que la chaleur engendrée par ledit composant électrique/électronique (12) puisse être dissipée par ledit composant de boîte (14) et/ou par ladite couverture (18).

8. Dispositif selon une quelconque des revendications 1 à 7, **caractérisé en ce que** ledit composant électrique/électronique (12), qui est reçu dans ledit espace intérieur de boîte, est constitué par une plaque de circuit imprimé, en particulier une plaque de circuit imprimé rigide ou en configuration solide.

9. Dispositif selon une quelconque des revendications 1 à 8, **caractérisé en ce que** ledit élément de liaison électriquement conducteur (16) est constitué par une plaque de circuit imprimé flexible, un grille de découpage encastré par injection, ou un câble, en particulier un câble plat.

10. Dispositif selon une quelconque des revendications 1 à 9, **caractérisé en ce qu'**un contact de masse est établi en particulier dudit composant électrique/électronique (12) avec ledit composant de boîte (14) et/ou ladite couverture (18), via une métallisation dudit composant électrique/électronique (12).

11. Procédé à monter un dispositif (10) à recevoir, au moins en partie, au moins un composant électrique/électronique (12) dans un espace intérieur d'une boîte, en particulier pour des véhicules utilitaires, ledit dispositif comprenant au moins un composant de boîte (14) formant ledit espace intérieur de boîte, au moins en partie, et une couverture (18) fermant, au moins en partie, ledit espace intérieur de boîte, dans lequel au moins un élément de liaison électriquement conducteur (16) pour un couplage électrique dudit composant électrique/électronique (12) à au moins un autre composant électrique/électronique, disposé en dehors dudit espace intérieur de boîte, est fixé moyennant ladite couverture (18), et dans lequel ledit composant électrique/électronique (12) est serré, pour sa fixation, entre au moins une partie de bord dudit composant de boîte (14) et au moins une partie de bord de ladite couverture (18), **caractérisé en ce que** ladite au moins une partie de bord de ladite couverture (18), qui serre ledit composant électrique/électronique, est configurée sous forme d'un bras élastique, à une première partie dudit bras élastique étant accouplée directement à ladite au moins une partie de bord dudit composant de boîte (14), pendant qu'une deuxième partie adjacente contigüe dudit bras élastique constitue un serrage (26) ensemble avec ledit composant de boîte (14).

12. Procédé selon la revendication 11, **caractérisé en ce que** ladite couverture (18) sert à la fixation, au moins en partie, dudit élément de liaison électriquement conducteur (16) moyennant au moins une autre partie de bord, qui est accouplée, au moins par tronçons respectifs, à au moins une autre partie de bord dudit composant de boîte (14).

13. Procédé selon une quelconque des revendications 11 ou 12, **caractérisé en ce que** ledit élément de liaison électriquement conducteur (16) set disposé entre ledit composant de boîte (14) et ladite couverture (18), en étant mis en contact, au moins par tronçons respectifs, audit composant de boîte (14) et à ladite couverture (18).

14. Procédé selon une quelconque des revendications 11 à 13, **caractérisé en ce que** ladite couverture (18) reçoit, au moins en partie, un joint d'étanchéité (20) au moins dans la zone de la fixation dudit élément de liaison électriquement conducteur (16).

15. Procédé selon une quelconque des revendications 11 à 14, **caractérisé en ce que** ladite couverture (18) reçoit un joint d'étanchéité (20) au moins à une autre partie de bord, qui accouple ladite couverture (18) audit composant de boîte (14), de façon, que ladite autre partie de bord reçoive ledit joint d'étanchéité, au moins en partie, en fixant ledit élément de liaison électriquement conducteur (16).

16. Procédé selon une quelconque des revendications 11 à 15, **caractérisé en ce que** ledit élément de liaison électriquement conducteur (16) est serré pour sa fixation entre au moins une autre partie de bord dudit composant de boîte (14) et au moins une autre partie de bord de ladite couverture (18).

17. Procédé selon une quelconque des revendications 11 à 16, **caractérisé en ce que** ledit composant électrique/électronique (12), qui est reçu dans ledit espace intérieur de boîte, est constitué par une plaque de circuit imprimé, en particulier une plaque de circuit imprimé rigide ou en configuration solide, qui est serrée par ladite couverture (18).

18. Procédé selon une quelconque des revendications 11 à 17, **caractérisé en ce que** ledit composant de boîte (14) et/ou ladite couverture (18) sont mis en contact, au moins par tronçons respectifs, avec ledit composant électrique/électronique (12) de façon, que la chaleur engendrée par ledit composant électrique/électronique (12) soit dissipée par ledit composant de boîte (14) et/ou par ladite couverture (18).

19. Procédé selon une quelconque des revendications 11 à 18, **caractérisé en ce que** ledit élément de liaison électriquement conducteur (16) est constitué par une plaque de circuit imprimé flexible, un grille de découpage encastré par injection, ou un câble, en particulier un câble plat, qui est fixé par le montage de ladite couverture (18).

20. Procédé selon une quelconque des revendications 11 à 19, **caractérisé en ce qu'**on réalise une métallisation dudit composant électrique/électronique (12), via laquelle un contact de masse est établis, en particulier dudit composant électrique/électronique (12) avec ledit composant de boîte (14) et/ou ladite couverture (18).

21. Couverture (18) pour un dispositif (10) (10) à recevoir, au moins en partie, au moins un composant électrique/électronique (12) dans un espace intérieur d'une boîte, en particulier pour des véhicules utilitaires, à la couverture étant apte à être accouplé à au moins un composant de boîte (14) formant un espace intérieur de boîte, au moins en partie, et audit espace intérieur de boîte étant apte à être fermé par la couverture (18), à la couverture (18) étant configurée d'une telle façon, qu'au moins un élément de liaison électriquement conducteur (16) pour un couplage électrique dudit composant électrique/électronique (12) à au moins un autre composant électrique/électronique, disposé en dehors dudit espace intérieur de boîte, soit fixé moyennant la couverture (18), quand la couverture (18) est accouplée audit composant de boîte (14), et dans laquelle la couverture (14) set configurée de telle façon, que ledit composant électrique/électronique (12) peut être serré entre au moins une partie de bord dudit composant de boîte (14) et au moins une partie de bord de ladite couverture (18), **caractérisée en ce que** ladite au moins une partie de bord de la couverture (18) est configurée sous forme d'un bras élastique, à une première partie dudit bras élastique étant apte à être accouplé directement à ladite au moins une partie de bord dudit composant de boîte (14), pendant qu'une deuxième partie adjacente contigüe dudit bras élastique constitue un serrage (26) ensemble avec ledit composant de boîte (14) en étant accouplé de la couverture (18)..
